# EUROPÄISCHE PATENTSCHRIFT

(11) **EP 1 194 618 B1**
(45) Veröffentlichungstag und Bekanntmachung des Hinweises auf die Patenterteilung: **08.10.2003**
(21) Anmeldenummer: 00949146.5
(22) Anmeldetag: 04.07.2000
(51) Int. Cl.: C30B 23/00, C30B 29/36

(54) **VERFAHREN ZUR SUBLIMATIONSZÜCHTUNG EINES SIC-EINKRISTALLS MIT AUFHEIZEN UNTER ZÜCHTUNGSDRUCK**
SUBLIMATION GROWTH METHOD FOR AN SIC MONOCRYSTAL WITH GROWTH-PRESSURE HEATING
PROCEDE DE PRODUCTION PAR SUBLIMATION D'UN MONOCRISTAL DE SIC AVEC CHAUFFAGE SOUS PRESSION DE CROISSANCE

(30) Priorität: 07.07.1999 DE 19931333
(43) Veröffentlichungstag der Anmeldung: 10.04.2002
(73) Patentinhaber: SIEMENS AKTIENGESELLSCHAFT, 80333 München (DE)
(72) Erfinder: STEIN, Rene, D-91341 Röttenbach (DE); KUHN, Harald, D-91056 Erlangen (DE); VÖLKL, Johannes, D-91056 Erlangen (DE)
(86) Internationale Anmeldenummer: DE0002174
(87) Internationale Veröffentlichungsnummer: WO01004391

(56) Entgegenhaltungen:
- EP-B- 0 389 533
- DE-A- 3 230 727
- PATENT ABSTRACTS OF JAPAN vol. 1999, no. 08, 30. Juni 1999 (1999-06-30) & JP 11 060390 A (DENSO CORP), 2. März 1999 (1999-03-02)
- WOO SIK YOO ET AL: "BULK CRYSTAL GROWTH OF 6H-SIC ON POLYTYPE-CONTROLLED SUBSTRATES THROUGH VAPOR PHASE AND CHARACTERIZATION" JOURNAL OF CRYSTAL GROWTH,NL,NORTH-HOLLAND PUBLISHING CO. AMSTERDAM, Bd. 115, Nr. 1 / 04, 2. Dezember 1991 (1991-12-02), Seiten 733-739, XP000322885 ISSN: 0022-0248 in der Anmeldung erwähnt

## Beschreibung

Die Erfindung betrifft ein Verfahren zur Sublimationszüchtung wenigstens eines SiC-Einkristalls, bei dem ein Vorrat aus festem Siliciumcarbid (SiC) in einen Vorratsbereich eines Tiegels und mindestens ein SiC-Keimkristall in mindestens einen Kristallbereich des Tiegels eingebracht werden, der Tiegel während einer Startphase auf Züchtungsbedingungen gebracht wird und der SiC-Einkristall während einer Züchtungsphase gezüchtet wird, indem das feste SiC des Vorrats zumindest teilweise sublimiert und in eine SiC-Gasphase mit SiC-Gasphasenkomponenten überführt wird, sowie die SiC-Gasphasenkomponenten zumindest teilweise zu dem SiC-Keimkristall transportiert und dort als aufwachsender SiC-Einkristall abgeschieden werden. Ein derartiges Verfahren zur Sublimationszüchtung eines SiC-Einkristalls ist beispielsweise aus der DE 32 30 727 C2 bekannt.

Bei dem bekannten Verfahren wird festes Siliciumcarbid (SiC), das sich in einem Vorratsbereich befindet, auf eine Temperatur zwischen 2000°C und 2500°C erhitzt und damit sublimiert. Eine durch die Sublimation entstehende SiC-Gasphase enthält als SiC-Gasphasenkomponenten unter anderem reines Silicium (Si) sowie die Carbidverbindungen Si₂C, SiC₂ und auch SiC.
Das Gasgemisch dieser SiC-Gasphase diffundiert durch eine poröse Graphitwand in einen Reaktions- oder Kristallbereich, in dem sich ein SiC-Keimkristall befindet. Auf diesem kristallisiert Siliciumcarbid aus der SiC-Gasphase bei einer Kristallisationstemperatur zwischen 1900°C und 2000°C aus. In dem Kristallbereich befindet sich neben dem Gasgemisch der SiC-Gasphase auch ein Schutzgas, vorzugsweise Argon (Ar). Über eine entsprechende Einleitung dieses Argon-Gases wird ein im Kristallbereich gewünschter Züchtungsdruck zwischen 1 mbar und 5 mbar eingestellt. Der Gesamtdruck im Kristallbereich setzt sich aus dem Dampfpartialdruck der SiC-Gasphase und dem Dampfpartialdruck des Argon-Gases zusammen.

Vor dem Beginn der eigentlichen Züchtungsphase wird der Tiegel und damit auch die Tiegelinnenzone auf eine Züchtungstemperatur erhitzt. Während dieser Aufheizphase wird in dem Tiegel durch Befüllung mit einem Schutzgas, beispielsweise mit Argon, ein Aufheizdruck eingestellt, der deutlich über einem später während der Züchtungsphase verwendeten Züchtungsdruck liegt. Nach Erreichen der Züchtungstemperatur wird der Druck dann durch Abpumpen auf den erheblich niedrigeren Züchtungsdruck reduziert.

Auch in der *EP 0 389 533 B1* wird ein Verfahren zur Sublimationszüchtung eines SiC-Einkristalls beschrieben, bei dem ein Tiegel vor der Züchtungsphase auf eine Züchtungstemperatur in der Größenordnung von 2200°C aufgeheizt wird, wobei gleichzeitig ein hoher Aufheizdruck von etwa 530 mbar eingestellt wird. Nach Erreichen der Züchtungstemperatur, die sich im übrigen im Vorratsbereich und im Kristallbereich geringfügig voneinander unterscheiden, so daß sich der für den Transport der SiC-Gasphasenkomponenten erforderliche Temperaturgradient einstellt, wird der Druck im Tiegel dann auf einen erheblich niedrigeren Züchtungsdruck von etwa 13 mbar eingestellt.

Ein weiteres Verfahren zur Sublimationszüchtung eines SiC-Einkristalls ist aus dem Aufsatz *Journal of Crystal Growth, Vol. 115, 1991, Seiten 733 bis 739* bekannt. Auch bei diesem Verfahren erfolgt ein Aufheizen des zur Züchtung eingesetzten Tiegels unter einem hohen Argongas-Druck von etwa 1000 mbar (= Atmosphärendruck). Sobald die gewünschte Züchtungstemperatur erreicht ist, wird der Argongas-Druck auf den Züchtungsdruck reduziert. Der Züchtungsdruck kann bei diesem Sublimationsverfahren auch in der Züchtungsphase noch variieren. Der Züchtungsdruck kann dabei Werte zwischen 1,33 mbar und 1000 mbar annehmen.

Auch in dem Übersichtsaufsatz *Electronics and Communications in Japan, Part 2, Vol. 81, No. 6, 1998, Selten 8-17* wird ein Verfahren zur Sublimationszüchtung eines SiC-Einkristalls beschrieben, bei dem das Aufheizen unter einem hohen Druck von etwa 800 mbar erfolgt. Der hohe Druck ist notwendig, um eine Kristallisation bei einer niedrigen Temperatur, d.h. bei einer Temperatur unterhalb der eigentlichen Züchtungstemperatur, zu vermeiden. Die Kristallisation bei niedriger Temperatur würde andernfalls nämlich zur Bildung eines unerwünschten Polytyps führen.

Die bekannten Verfahren heizen somit allesamt den Tiegel zunächst unter hohem Aufheizdruck auf die gewünschte Züchtungstemperatur auf, um danach den Druck auf den erheblich niedrigeren Züchtungsdruck zu reduzieren. Es zeigt sich jedoch, daß bei diesen Verfahren die Kristallqualität des aufwachsenden SiC-Einkristalls beeinträchtigt werden und daraus insbesondere eine unerwünscht hohe Defektbildungsrate resultieren kann.

Die Aufgabe der Erfindung besteht nun darin, ein Verfahren der eingangs bezeichneten Art anzugeben, das ein verbessertes Ankeimen des aufwachsenden SiC-Einkristalls auf dem SiC-Keimkristall gewährleistet und damit auch eine höhere Kristallqualität des aufwachsenden SiC-Einkristalls ermöglicht. Insbesondere soll eine unkontrollierte Anlagerung von SiC-Gasphasenkomponenten an einer Kristallisationsoberfläche sicher vermieden werden.

Zur Lösung der Aufgabe wird ein Verfahren entsprechend den Merkmalen des Patentanspruchs 1 angegeben.

Bei dem erfindungsgemäßen Verfahren zur Sublimationszüchtung wenigstens eines SiC-Kristalls handelt es sich um ein Verfahren, bei dem
a) ein Vorrat aus festem SiC in einen Vorratsbereich eines Tiegels und mindestens ein SiC-Keimkristall in mindestens einen Kristallbereich des Tiegels eingebracht werden,
b) der Tiegel während einer Startphase auf Züchtungsbedingungen gebracht wird,
c) der SiC-Einkristall während einer Züchtungsphase gezüchtet wird, indem das feste SiC des Vorrats zumindest teilweise sublimiert und in eine SiC-Gasphase mit SiC-Gasphasenkomponenten überführt wird, sowie die SiC-Gasphasenkomponenten zumindest teilweise zu dem SiC-Keimkristall transportiert und dort als aufwachsender SiC-Einkristall abgeschieden werden,
   wobei der Tiegel während der Startphase
d) zunächst evakuiert und dann mit einem Schutzgas befüllt wird, bis im Tiegel ein Züchtungsdruck erreicht ist, sowie
e) zunächst auf eine Zwischentemperatur und dann in einer Aufheizphase ausgehend von der Zwischentemperatur mit einer Aufheizgeschwindigkeit von höchstens 20°C/min auf eine Züchtungstemperatur erhitzt wird.

Die Erfindung beruht dabei auf der Erkenntnis, daß sich bei dem bislang praktizierten Verfahren nach dem Stand der Technik die SiC-Gasphase am SiC-Keimkristall insbesondere während der Druckabsenkung auf den Züchtungsdruck nicht im thermodynamischen Gleichgewicht mit dem SiC-Keimkristall befindet. Dadurch kann es während der Druckabsenkung zu einer unkontrollierten Anlagerung von SiC-Gasphasenkomponenten an einer Kristallisationsoberfläche des SiC-Keimkristalls kommen. Dies kann sich ungünstig auf das zu Beginn des Züchtungsprozesses stattfindende Ankeimen des aufwachsenden SiC-Einkristalls auf dem SiC-Keimkristall auswirken.

Demgegenüber kann ein Ankeimen der SiC-Gasphasenkomponenten auf einer Kristallisationsoberfläche des SiC-Keimkristalls erheblich verbessert werden, indem das Aufheizen des Tiegels, des SiC-Keimkristalls und des SiC-Vorrats auf die Züchtungstemperatur im wesentlichen bereits bei dem später auch während der Züchtungsphase vorgesehenen Züchtungsdruck vorgenommen wird. Dadurch entfällt insbesondere das beim Stand der Technik übliche Absenken des Drucks nach Erreichen der Züchtungstemperatur und auch das durch diese Druckabsenkung hervorgerufene unkontrollierte Anwachsen von SiC-Gasphasenkomponenten auf der Kristallisationsoberfläche des SiC-Keimkristalls. Durch ein langsames Aufheizen mit einer Aufheizgeschwindigkeit von höchstens 20°C/min, vorzugsweise mit einer Aufheizgeschwindigkeit von höchstens 10°C/min, und einem bereits während dieser Aufheizphase eingestellten Züchtungsdruck im Tiegel findet nämlich bereits während dieser Aufheizphase ein geringfügiges und kontrolliertes Ankeimen von SiC-Gasphasenkomponenten an der Kristallisationsoberfläche des SiC-Keimkristalls statt. Unter dem Züchtungsdruck wird in diesem Zusammenhang stets der Gesamtdruck im Tiegel während der Züchtung verstanden.

Durch die langsame Aufheizgeschwindigkeit bei gleichbleibendem Druck im Tiegel befinden sich die SiC-Gasphase und der SiC-Keimkristall praktisch immer nahe am thermodynamischen Gleichgewicht. Dadurch wird bereits zu diesem frühen Zeitpunkt eine gute Grundlage für den später während der Züchtungsphase aufwachsenden SiC-Einkristall geschaffen. Das kontrollierte Ankeimen führt zu einer guten Verbindung zwischen dem SiC-Keimkristall und dem aufwachsenden SiC-Keimkristall. Die resultierende Verbindung ist praktisch frei von Störstellen, die ansonsten als Ausgangspunkt für die Bildung von Kristalldefekten dienen könnten. Der SiC-Einkristall wächst damit mit einer sehr hohen Kristallqualität auf.

Beim Stand der Technik wird demgegenüber ein Ankeimen während der Aufheizphase gezielt durch das in den Tiegel eingeleitete Schutzgas und durch den damit eingestellten hohen Druck unterdrückt. Der hohe Argongas-Druck verhindert dabei eine Diffusion der SiC-Gasphasenkomponenten zu dem SiC-Keimkristall, so daß ein Ankeimen praktisch unmöglich ist. Sobald der hohe Druck nach Erreichen der Züchtungstemperatur auf den erheblich niedrigeren Züchtungsdruck reduziert wird, setzt der Ankeimvorgang unmittelbar ein. Da die einzelnen SiC-Gasphasenkomponenten aber unterschiedliche Diffusionskonstanten in dem Argon-Gas aufweisen, gelangen sie nach Absenken des hohen Argongas-Drucks auch unterschiedlich schnell vom Vorrat zum SiC-Keimkristall. Vor dem SiC-Keimkristall bildet sich dann eine SiC-Gasphase aus, deren SiC-Gasphasenkomponenten nicht in der thermodynamischen Gleichgewichtskonzentration vorliegen. Damit läuft die beginnende Kristallbildung jedoch wesentlich unkontrollierter ab als bei Bedingungen, die sich nahe am thermodynamischen Gleichgewicht bewegen. Eine kontrollierte Beeinflussung des Ankeimens ist dann nicht möglich.

Besondere Ausgestaltungen des erfindungsgemäßen Verfahrens ergeben sich aus den abhängigen Unteransprüchen.

Vorteilhaft ist eine Ausgestaltung des Verfahrens, bei der die SiC-Gasphase, die sich am SiC-Keimkristall ausbildet, während der Startphase, und insbesondere während der Aufheizphase, so eingestellt wird, daß sie eine für ein beginnendes Kristallwachstum auf dem SiC-Keimkristall erforderliche Mindestkonzentration an SiC-Gasphasenkomponenten aufweist. Diese Einstellung kann dabei insbesondere über einen entsprechenden Temperaturverlauf innerhalb des Tiegels erreicht werden. Vorzugsweise werden dazu der Vorrat aus festem SiC und der SiC-Keimkristall auf verschiedene Temperatur gebracht, so daß sich ein geringer Temperaturgradient mit einem Temperaturgefälle zum SiC-Keimkristall hin einstellt.

Am SiC-Keimkristall stellt sich dann eine leicht übersättigte Konzentration der SiC-Gasphasenkomponenten ein. Dadurch wird einerseits ein unkontrolliertes Abdampfen insbesondere von Silicium aus dem SiC-Keimkristall verhindert und andererseits ein Aufwachsen von kristallinem Material auf dem SiC-Keimkristall mit einer hohen Wachstumsrate unterdrückt. Die geringe Übersättigung bewirkt lediglich ein schwaches Ankeimen auf dem SiC-Keimkristall. Durch diese Maßnahme wird somit das bereits während der Aufheizphase erwünschte Ankeimen zusätzlich unterstützt.

Besonders günstig ist es, wenn ein Temperaturgradient zwischen dem Vorratsbereich mit dem Vorrat aus festem SiC und dem SiC-Keimkristall auf einen Wert von höchstens 20°C/cm eingestellt wird. Da während der Aufheizphase lediglich ein Ankeimen am SiC-Keimkristall in Gang gesetzt werden soll, ist für die SiC-Gasphasenkomponenten nur eine geringe Transportrate hin zum SiC-Keimkristall erforderlich.

Dies kann man beispielsweise über eine sehr niedrige Temperaturdifferenz zwischen dem SiC-Vorrat und dem SiC-Keimkristall erreichen. Günstig für die prozeßtechnische Handhabbarkeit und die Reproduzierbarkeit ist es, wenn eine größere Temperaturdifferenz zwischen dem SiC-Vorrat und dem SiC-Keimkristall eingestellt wird und der der Gasfluß der SiC-Gasphasenkomponenten dann über konstruktive Maßnahmen im Tiegel, die die Diffusionsgeschwindigkeit reduzieren und/oder den Strömungswiderstand erhöhen, wieder abgebremst wird. Mit beiden Methoden erhält man die gewünschte niedrige Transportrate.

Die Einstellung des gewünschten Temperaturgradienten zwischen dem Vorratsbereich und dem Kristallbereich kann gegebenenfalls über eine zweigeteilte und getrennt steuerbare Heizeinrichtung, die sich außerhalb des Tiegels befindet, erfolgen. Bei Bedarf kann die Heizeinrichtung auch mehr als zwei separate Teilheizeinrichtungen umfassen. Damit läßt sich der Temperaturverlauf in der Tiegelinnenzone dann exakt steuern. Die Heizeinrichtung kann dabei vorzugsweise induktiv, jedoch auch als Widerstandsheizung ausgebildet sein.

Vorteilhaft ist eine weitere Ausführungsform, bei der die Aufheizgeschwindigkeit während der Aufheizphase ausgehend von einem Anfangswert verändert, insbesondere reduziert wird. Der Anfangswert der Aufheizgeschwindigkeit kann dabei bis zu 20°C/min betragen. Besonders vorteilhaft ist es, wenn die Aufheizgeschwindigkeit um so niedriger eingestellt wird, je mehr sich die Temperatur in der Tiegelinnenzone an die letztendlich einzustellende Züchtungstemperatur annähert. Gegen Ende der Aufheizphase kann die Aufheizgeschwindigkeit dabei insbesondere nur noch einen Wert von höchstens 10°C/min, vorzugsweise von höchstens 1°C/m betragen.

In einer weiteren günstigen Variante wird die Aufheizgeschwindigkeit ausgehend von dem Anfangswert deshalb schrittweise mit zunehmender Dauer der Aufheizphase reduziert. Durch dieses langsame und insbesondere kontrollierte Annähern der Temperatur an die Züchtungstemperatur erreicht man, daß die sich am SiC-Keimkristall einstellende SiC-Gasphase zu jedem Zeitpunkt der Aufheizphase fast im thermodynamischen Gleichgewicht mit dem SiC-Keimkristall befindet. Die Abweichung vom thermodynamischen Gleichgewicht ist dabei gerade so groß, daß der erwünschte Ankeimprozeß zustande kommt. Eine Störung dieser Verhältnisse durch eine etwaige starke Druckveränderung im Tiegel findet insbesondere gegen Ende der Aufheizphase nicht mehr statt. Der Züchtungsdruck wird nämlich üblicherweise zu Beginn der Aufheizphase oder auch schon vorher durch entsprechendes Befüllen des evakuierten Tiegels mit dem Schutzgas eingestellt.

Es ist jedoch auch möglich, die Aufheizgeschwindigkeit ausgehend von dem Anfangswert kontinuierlich zu reduzieren. Dies kann dann entweder mit einem konstanten Gradienten der Aufheizgeschwindigkeit oder nach einem anderen beliebigen, für die Abnahme der Aufheizgeschwindigkeit vorgegebenen Verlauf erfolgen. Generell ist es günstig, die Aufheizgeschwindigkeit umso stärker zu reduzieren, je mehr sich die Temperatur in der Tiegelinnenzone der endgültigen Züchtungstemperatur annähert.

Bevorzugt ist eine weitere Ausführungsform des Verfahrens, bei der der gewünschte Züchtungsdruck durch ein Befüllen mit mindestens einem der Schutzgase Argon (Ar) ,Helium (He) und Wasserstoff (H₂) eingestellt wird. Wasserstoff ist in diesem Zusammenhang ebenfalls als Schutzgas zu interpretieren. Der Züchtungsdruck wird vorzugsweise auf einen Wert zwischen 1 und 20 mbar eingestellt. Dies wird durch eine entsprechende Steuerung der in den Tiegel eingeleiteten Gasmenge erreicht. Bei der Züchtung von α-SiC ist es günstig, wenn der Züchtungsdruck eingestellt wird, bevor die Temperatur im Tiegel einen Wert von 1800°C, insbesondere von 1600°C überschreitet. Ansonsten ist jeder beliebige Zeitpunkt während der Startphase prinzipiell zur Einstellung des Züchtungsdrucks geeignet.

Bis zu der genannten Temperatur von 1800°C ist die Sublimationsrate des Siliciumcarbids im Vorrat und am Keimkristall selbst im Vakuum oder bei einem nur sehr niedrigen Druck praktisch vernachlässigbar. Bis zu dieser Temperatur bildet sich somit noch keine nennenswerte SiC-Gasphase, so daß auch einem thermodynamischen Gleichgewicht zwischen der SiC-Gasphase und dem SiC-Keimkristall noch keine entscheidende Bedeutung zukommt. Da die Sublimationsrate im Vakuum ab einer Temperatur von etwa 1600°C langsam zu steigen beginnt, kann es vorteilhaft sein, den Züchtungsdruck bereits vor Erreichen von 1600°C einzustellen.

Als bevorzugte, im Verlauf der Aufheizphase einzustellende Züchtungstemperatur kommt ein Wert zwischen 2100°C und 2300°C in Frage. Dieser Bereich der Züchtungstemperatur ist in erster Linie für die Züchtung von α-SiC günstig. β-SiC wird dagegen üblicherweise bei einer niedrigeren Temperatur in der Größenordnung von etwa 1800°C gezüchtet. Da in der Tiegelinnenzone ein gewisser Temperaturverlauf mit zum Teil unterschiedlichen Temperaturwerten in den jeweiligen Tiegelbereichen, beispielsweise im Vorrats- und im Kristallbereich, vorliegt, wird unter der Züchtungstemperatur in diesem Zusammenhang eine über die Tiegelinnenzone gemittelte Temperatur verstanden.

Bei einer weiteren bevorzugten Variante wird die Zwischentemperatur, auf die der Tiegel während der Startphase erhitzt wird, auf einen Wert zwischen 1000°C und 1400°C eingestellt.

Bevorzugte Ausführungsbeispiele werden nunmehr anhand der Zeichnung näher erläutert. Zur Verdeutlichung ist die Zeichnung nicht maßstäblich ausgeführt, und gewisse Merkmale sind schematisiert dargestellt. Im einzelnen zeigen:
- Figur 1: eine Vorrichtung zur Sublimationszüchtung eines SiC-Einkristalls mit Mitteln zur Temperatur- und Druckeinstellung und
- Figur 2: ein Diagramm mit einem Temperatur- und Druckverlauf während deiner Startphase der Sublimationszüchtung.

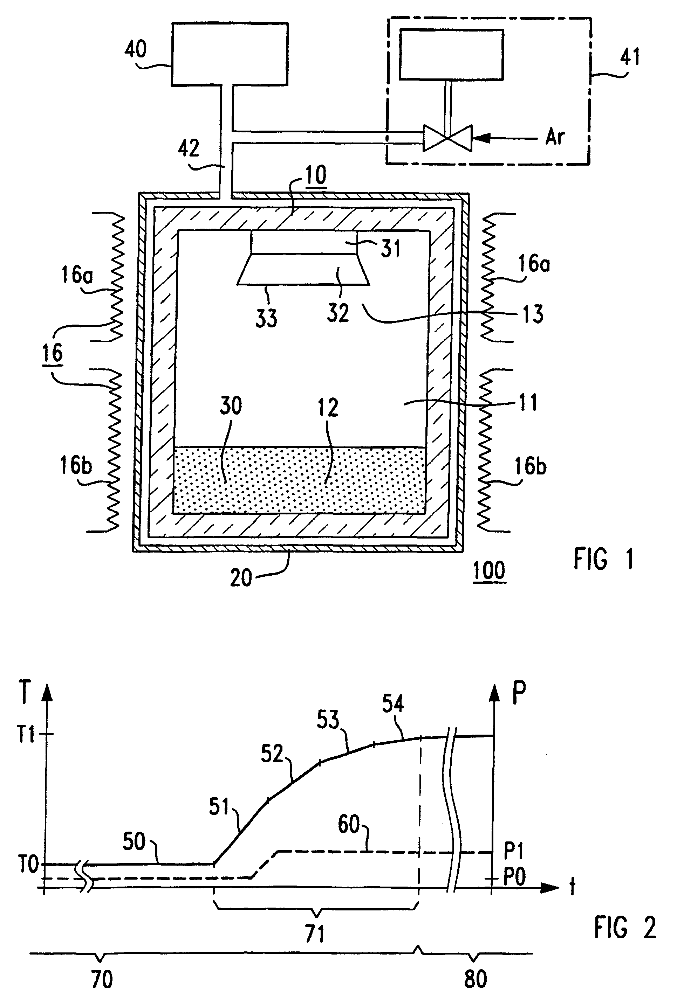

Einander entsprechende Teile sind in den Figuren 1 und 2 mit denselben Bezugszeichen versehen.

In Figur 1 ist eine Vorrichtung 100 zur Sublimationszüchtung eines SiC-Einkristalls 32, der insbesondere in Form eines Volumeneinkristalls aus α-SiC auf einem SiC-Keimkristall 31 aufwächst, in Schnittdarstellung gezeigt. Die Vorrichtung 100 umfaßt einen Tiegel 10 mit einer Tiegelinnenzone 11, die einen Vorratsbereich 12 und einen gegenüberliegenden Kristallbereich 13 enthält.

In dem Vorratsbereich 12 befindet sich ein Vorrat aus festem SiC 30, das sowohl aus einem kompakten SiC-Materialblock, insbesondere aus gesintertem SiC, oder auch aus pulverförmigem, polykristallinem SiC bestehen kann. In dem Kristallbereich 13 ist ein SiC-Keimkristall 31 angeordnet, auf den der SiC-Einkristall 32 während der Sublimationszüchtung aufwächst. Eine momentane Wachstumsgrenze wird als Kristallisationsoberfläche 33 bezeichnet. Diese befindet sich zu Beginn des Sublimationsprozesses noch an einer Oberfläche des SiC-Keimkristalls 31. Später stellt sie dann jeweils die Oberfläche des aufwachsenden SiC-Einkristalls 32 dar, an dem das Kristallwachstum stattfindet.

Außerhalb des Tiegels 10 befindet sich eine Heizeinrichtung 16, die im Ausführungsbeispiel von Figur 1 zweiteilig ausgebildet ist. Sie besteht aus einer ersten und zweiten Teilheizeinrichtung 16a bzw. 16b. Über die Heizeinrichtung 16 läßt sich die Tiegelinnenzone 11 erhitzen, so daß das feste SiC 30 des Vorrats sublimiert und in eine SiC-Gasphase mit SiC-Gasphasenkomponenten überführt wird.

Durch einen Diffusions- und einen Konvektionsprozeß werden die SiC-Gasphasenkomponenten dann vom Vorratsbereich 12 zum Kristallbereich 13 transportiert. Dort wird ein Teil der SiC-Gasphasenkomponenten als aufwachsender SiC-Einkristall 32 auf dem SiC-Keimkristall 31 abgeschieden. Um den Transport und das Kristallwachstum zu unterstützen, wird über die Heizeinrichtung 16 ein leichtes Temperaturgefälle von etwa 5°C zwischen dem Vorratsbereich 12 und dem Kristallbereich 13 eingestellt. Die zweiteilige Ausführung der Heizeinrichtung 16 eignet sich für die Einstellung eines solchen Temperaturgradienten besonders gut.

Ein weiterer wichtiger Parameter für den Züchtungsprozeß ist der in der Tiegelinnenzone 11 herrschende Druck. Die Vorrichtung 100 enthält deshalb auch Evakuierungsmittel 40 sowie Gaszuführungsmittel 41, die über eine Zu-/Ableitung 42 mit einem vakuumfesten Gefäß 20, in dem sich der Tiegel 10 befindet, verbunden sind. Da der Tiegel 10 nicht vollkommen dicht ist, folgen die Druckverhältnisse im Tiegel 10 denen im Inneren des vakuumfesten Gefäßes 20. Der Druck im Tiegel 10 läßt sich also über den im vakuumfesten Gefäß 20 einstellen.

Über die Evakuierungsmittel 40 wird das vakuumfeste Gefäß 20 und damit auch der Tiegel 10 evakuiert oder zumindest auf eine Atmosphäre mit einem sehr niedrigen Restdruck in der Größenordnung von höchstens 10⁻³ mbar gebracht. Die Evakuierung erfolgt üblicherweise, solange sich die gesamte Vorrichtung 100 noch auf Raumtemperatur befindet. Sie kann jedoch prinzipiell auch zu einem späteren Zeitpunkt durchgeführt werden. Die Gaszuführungsmittel 41 ermöglichen dann ein Befüllen des vakuumfesten Gefäßes 20 und des Tiegels 10 mit einem Schutzgas, im vorliegenden Fall mit Argon-Gas. Die dem vakuumfesten Gefäß 20 zugeführte und über die Gaszuführungsmittel 41 steuerbare Gasmenge bestimmt dann den Druck in der Tiegelinnenzone 11.

Mit der Heizeinrichtung 16, den Evakuierungsmitteln 40 sowie den Gaszuführungsmitteln 41 können die für den Sublimationsprozeß relevanten Züchtungsbedingungen, insbesondere eine entsprechende Züchtungstemperatur T1 und ein entsprechender Züchtungsdruck P1 in der Tiegelinnenzone 11, eingestellt werden. Darüber hinaus läßt sich auch ein definiertes Temperaturgefälle innerhalb des Tiegels 10 einstellen.

Für ein Kristallwachstum mit sehr hoher Qualität ist nun die Kontrolle der Züchtungsbedingungen nicht nur während einer eigentlichen Züchtungsphase 80, sondern auch schon vorher entscheidend. In Figur 2 ist daher ein Diagramm mit einem Temperaturverlauf 50 (durchgezogene Linie) und einem Druckverlauf 60 (gestrichelte Linie) während einer der Züchtungsphase 80 vorgeschalteten Startphase 70 dargestellt. In dem Diagramm sind auf der Abszisse eine Zeit t, auf der linken Ordinate eine (Tiegel-)Temperatur T und auf der rechten Ordinate ein (Tiegel-)Druck P jeweils in willkürlichen Einheiten aufgetragen.

Die Startphase 70 beinhaltet insbesondere eine Aufheizphase 71, während der der Tiegel 10 auf seine endgültige Züchtungstemperatur T1 aufgeheizt wird. Ausgangspunkt der Aufheizphase 71 ist eine Zwischentemperatur T0, die einen Wert von beispielsweise 1200°C annehmen kann. Die Zwischentemperatur T0 wird während der Startphase 70 zu einem in dem Diagramm von Figur 2 nicht dargestellten früheren Zeitpunkt eingestellt.

Eine Aufheizgeschwindigkeit wird während der Aufheizphase 71 um so stärker reduziert, je näher sich die Temperatur T im Tiegel 10 der Züchtungstemperatur T1 annähert. Der Temperaturverlauf 50 enthält deshalb während der Aufheizphase 71 Bereiche 51, 52, 53 und 54 mit jeweils zumindest annähernd konstanter Aufheizgeschwindigkeit. Im ersten Bereich 51 liegt die Aufheizgeschwindigkeit bei etwa 10°C/min, im zweiten Bereich 52 bei etwa 5°C/min, im dritten Bereich 53 bei etwa 2°C/min und im vierten Bereich 54 bei etwa 1°C/min. Eine andere Stückelung des Verlaufs der Aufheizgeschwindigkeit ist jedoch ebenso möglich.

Der neben dem Temperaturverlauf 50 ebenfalls eingetragene Druckverlauf 60 ist in dem Diagramm von Figur 2 mit gestrichelter Linie dargestellt. Ausgangspunkt für den Druckverlauf 60 im Tiegel 10 ist ein Restdruck P0, der durch eine Evakuierung des vakuumfesten Gefäß 20 und des Tiegels 10 eingestellt wird. Die Evakuierung findet dabei zu einem im Diagramm nicht dargestellten Zeitpunkt statt, zu dem sich der Tiegel 10 noch auf Raumtemperatur befindet. Zu Beginn der Aufheizphase 71 wird das vakuumfeste Gefäß 20 dann mit Argon-Gas befüllt, so daß sich auch die Druckverhältnisse im Tiegel 10 entsprechend verändern. Der Druck P im Tiegel 10 steigt dadurch vom Restdruck P0 auf den Züchtungsdruck P1, der dann für die verbleibende Zeitdauer der Aufheizphase 71 und auch während der anschließenden Züchtungsphase 80 im wesentlichen konstant gehalten wird.

Entscheidend für die Prozeßführung während der Startphase 70 ist zum einen das langsame Aufheizen auf die Züchtungstemperatur T1 mit schrittweise reduzierter Aufheizgeschwindigkeit sowie das Einstellen des Züchtungsdrucks P1 bereits während der Aufheizphase 71. Damit setzt noch in der Aufheizphase 71 ein leichtes Ankeimen am SiC-Keimkristall 31 ein. In der folgenden Züchtungsphase 80 wächst der SiC-Einkristall 32 dann aufgrund dieser Maßnahme mit sehr guter Kristallqualität auf den SiC-Keimkristall 31 auf. Das Ankeimen in der Aufheizphase 71 führt nämlich zu einem besonders störungsfreien Übergang zwischen dem SiC-Keimkristall 31 und dem SiC-Einkristall 32.

Die Vorrichtung 100 ist im Ausführungsbeispiel von Figur 1 nur zur Züchtung eines einzigen SiC-Einkristalls 32 ausgelegt. Dies bedeutet jedoch keine Einschränkung, denn die Vorrichtung 100 und das zugrunde liegende Verfahren lassen sich ohne weiteres auch für eine Züchtung mehrerer SiC-Einkristalle einsetzen.

Der Polytyp des gezüchteten SiC-Einkristalls 32 ist prinzipiell beliebig. Mit dem Verfahren lassen sich alle gängigen SiC-Polytypen wie z.B. 4H-SiC, 6H-SiC oder 15R-SiC herstellen. Auch kubisches SiC vom 3C-SiC-Polytyp kann gezüchtet werden.

Wenn als SiC-Keimkristall 31 ein fehlorientierter SiC-Keimkristall mit einer stufenförmig strukturierten Oberfläche verwendet wird, kann sich dies ebenfalls günstig auf das Ankeimen auswirken. Die Stufen des fehlorientierten SiC-Keimkristalls bieten nämlich bevorzugte Ausgangspunkte für den Ankeimprozeß, der dadurch definierter ablaufen kann.

## Patentansprüche

1. Verfahren zur Sublimationszüchtung wenigstens eines SiC-Einkristalls (32), bei dem
a) ein Vorrat aus festem SiC (30) in einen Vorratsbereich (12) eines Tiegels (10) und mindestens ein SiC-Keimkristall (31) in mindestens einen Kristallbereich (13) des Tiegels (10) eingebracht werden,
b) der Tiegel (10) während einer Startphase (70) auf Züchtungsbedingungen gebracht wird,
c) der SiC-Einkristall (32) während einer Züchtungsphase (80) gezüchtet wird, indem das feste SiC (30) des Vorrats zumindest teilweise sublimiert und in eine SiC-Gasphase mit SiC-Gasphasenkomponenten überführt wird, sowie die SiC-Gasphasenkomponenten zumindest teilweise zu dem SiC-Keimkristall (31) transportiert und dort als aufwachsender SiC-Einkristall (32) abgeschieden werden,
**dadurch gekennzeichnet, daß** der Tiegel (10) während der Startphase (70)
d) zunächst evakuiert und dann mit einem Schutzgas befüllt wird, bis im Tiegel (10) ein Züchtungsdruck (P1) erreicht ist, sowie
e) zunächst auf eine Zwischentemperatur (T0) und dann in einer Aufheizphase (71) ausgehend von der Zwischentemperatur (T0) mit einer Aufheizgeschwindigkeit von höchstens 20°C/min auf eine Züchtungstemperatur (T1) erhitzt wird.

2. Verfahren nach Anspruch 1, **dadurch gekennzeichnet, daß** während der Startphase (70) in der am SiC-Keimkristall (31) herrschenden SiC-Gasphase eine Mindestkonzentration an SiC-Gasphasenkomponenten eingestellt wird, ab der ein Kristallwachstum auf dem SiC-Keimkristall (31) beginnt.

3. Verfahren nach Anspruch 1 oder 2, **dadurch gekennzeichnet, daß** während der Aufheizphase (71) zwischen dem Vorratsbereich (12) und dem SiC-Keimkristall (32) eine Temperaturgradient von höchstens 20°C/cm eingestellt wird.

4. Verfahren nach einem der vorhergehenden Ansprüche, **dadurch gekennzeichnet, daß** die Aufheizgeschwindigkeit während der Aufheizphase (71) ausgehend von einem Anfangswert auf einen Wert von höchstens 10°C/min reduziert wird.

5. Verfahren nach Anspruch 4, **dadurch gekennzeichnet, daß** die Aufheizgeschwindigkeit während der Aufheizphase (71) ausgehend von einem Anfangswert schrittweise reduziert wird.

6. Verfahren nach einem der vorhergehenden Ansprüche, **dadurch gekennzeichnet, daß** der evakuierte Tiegel (10) mit mindestens einem der Schutzgase Argon, Helium und Wasserstoff befüllt wird.

7. Verfahren nach einem der vorhergehenden Ansprüche, **dadurch gekennzeichnet, daß** der Züchtungsdruck (P1) auf einen Wert zwischen 1 und 20 mbar eingestellt wird.

8. Verfahren nach einem der vorhergehenden Ansprüche, **dadurch gekennzeichnet, daß** die Züchtungstemperatur (T1) auf einen Wert zwischen 2100°C und 2300°C eingestellt wird.

9. Verfahren nach einem der vorhergehenden Ansprüche, **dadurch gekennzeichnet, daß** der Tiegel (10) während der Startphase (70) auf eine Zwischentemperatur (T0) von zwischen 1000°C und 1400°C erhitzt wird.

## Claims

1. Method for sublimation growth of at least one SiC single crystal (32), in which
a) a store of solid SiC (30) is placed into a storage area (12) of a crucible (10) and at least one SiC seed crystal (31) is placed into at least one crystal area (13) of the crucible (10),
b) the crucible (10) is brought to growth conditions during a starting phase (70),
c) the SiC single crystal (32) is grown during a growth phase (80), in that solid SiC (30) from the store is at least partially sublimated and transferred to an SiC gas phase with SiC gas phase components, and the SiC gas phase components are at least partially transported to the SiC seed crystal (31) and deposited there as a growing SiC single crystal (32),
**characterised in that** during the starting phase (70) the crucible (10)
d) is first evacuated and then filled with a protective gas, until a growth pressure (P1) is reached in the crucible (10), and
e) is first heated to an interim temperature (T0) and then in a heating phase (71) is heated from the interim temperature (T0) to a growth temperature (T1) at a maximum rate of heating of 20°C/min.

2. Method according to Claim 1, **characterised in that** during the starting phase (70) a minimum concentration of SiC gas phase components is set in the SiC gas phase prevailing at the SiC seed crystal (31), as of which crystal growth begins on the SiC seed crystal (31).

3. Method according to Claim 1 or 2, **characterised in that** during the heating phase (71) a maximum temperature gradient of 20°C/cm is set between the storage area (12) and the SiC seed crystal (32).

4. Method according to one of the preceding claims, **characterised in that** starting from an initial value the rate of heating is reduced during the heating phase (71) to a maximum value of 10°C/min.

5. Method according to Claim 4, **characterised in that** the rate of heating is gradually reduced during the heating phase (71) starting from an initial value.

6. Method according to one of the preceding claims, **characterised in that** the evacuated crucible (10) is filled with at least one of the protective gases argon, helium and hydrogen.

7. Method according to one of the preceding claims, **characterised in that** the growth pressure (P1) is set at a value between 1 and 20 mbar.

8. Method according to one of the preceding claims, **characterised in that** the growth temperature (T1) is set to a value between 2100°C and 2300°C.

9. Method according to one of the preceding claims, **characterised in that** the crucible (10) is heated during the starting phase (70) to an interim temperature (T0) of between 1000°C and 1400°C.

## Revendications

1. Procédé de croissance par sublimation d'au moins un monocristal (32) de SiC, dans lequel :
f) on introduit une réserve de SiC solide dans une partie (12) de réserve d'un creuset (10) et au moins un cristal (31) germe de SiC dans au moins une partie (13) de cristal du creuset (10),
g) on met le creuset (10) pendant une phase (70) de début dans des conditions de croissance,
h) on fait croître le monocristal (32) SiC pendant une phase (80) de croissance en sublimant le SiC (30) solide de la réserve au moins en partie et en le transformant en une phase gazeuse de SiC ayant des constituants en phase gazeuse de SiC, et on transporte les constituants en phase gazeuse de SiC au moins en partie au cristal (31) germe de SiC et on les y dépose sous la forme d'un monocristal (32) de SiC en croissance,
**caractérisé en ce que** pendant la phase (70) de début,
i) on fait d'abord le vide dans le creuset (10), puis on l'emplit d'un gaz de protection jusqu'à obtenir dans le creuset (10) une pression (P1) de croissance, ainsi que
j) on porte d'abord le creuset (10) à une température (T0) intermédiaire, puis dans une phase (71) de chauffage, à partir de la température (T0) intermédiaire et avec une vitesse de chauffage d'au plus 20°C/min, à une température (T1) de croissance.

2. Procédé suivant la revendication 1, **caractérisé en ce que** pendant la phase (70) de début, on établit, dans la phase gazeuse de SiC régnant sur le cristal (31) germe de SiC, une concentration minimale de constituants en phase gazeuse de SiC à partir de laquelle une croissance de cristal commence sur le cristal (31 ) germe de SiC.

3. Procédé suivant la revendication 1 ou 2, **caractérisé en ce que** pendant la phase (71) de chauffage, on établit, entre la partie (12) de réserve et le cristal (32) germe de SiC, un gradient de température d'au plus 20°C/cm.

4. Procédé suivant l'une des revendications précédentes, **caractérisé en ce que** l'on réduit la vitesse de chauffage pendant la phase (71) de chauffage à partir d'une valeur initiale à une valeur d'au plus 10°C/min.

5. Procédé suivant la revendication 4, **caractérisé en ce que** l'on réduit pas à pas la vitesse de chauffage pendant la phase (71) de chauffage à partir d'une valeur initiale.

6. Procédé suivant l'une des revendications précédentes, **caractérisé en ce que** l'on emplit le creuset (10) mis sous vide d'au moins l'un des gaz de protection argon, hélium et hydrogène.

7. Procédé suivant l'une des revendications précédentes, **caractérisé en ce que** l'on établit la pression (P1) de croissance à une valeur comprise entre 1 et 20 millibars.

8. Procédé suivant l'une des revendications précédentes, **caractérisé en ce que** l'on établit la température (T1) de croissance à une valeur comprise entre 2100°C et 2300°C.

9. Procédé suivant l'une des revendications précédentes, **caractérisé en ce que** l'on porte le creuset (10), pendant la phase (70) de début, à une température (T0) intermédiaire comprise entre 1000°C et 1400°C.
